# FASCICULE DE BREVET EUROPEEN

(11) **EP 0 925 599 B1**
(45) Date de publication et mention de la délivrance du brevet: **13.06.2001**
(21) Numéro de dépôt: 97938977.2
(22) Date de dépôt: 03.09.1997
(51) Int. Cl.: H01J 37/05

(54) **FILTRE D'ENERGIE, MICROSCOPE ELECTRONIQUE A TRANSMISSION ET PROCEDE DE FILTRAGE D'ENERGIE ASSOCIE**
ENERGIEFILTER, TRANSMISSIONSELEKTRONENMIKROSKOP UND ASSOZIIERTES ENERGIEFILTERUNGSVERFAHREN
ENERGY FILTER, TRANSMISSION ELECTRON MICROSCOPE AND ASSOCIATED METHOD FOR FILTERING ENERGY

(30) Priorité: 12.09.1996 FR 9611146
(43) Date de publication de la demande: 30.06.1999
(73) Titulaire: CENTRE NATIONAL DE LA RECHERCHE SCIENTIFIQUE, 75016 Paris Cédex (FR)
(72) Inventeur: JOUFFREY, Bernard, F-75007 Paris (FR); HEBERT-SOUCHE, Cécile, A-3003 GABLITZ (AT)
(74) Mandataire: Michelet, Alain
(86) Numéro de dépôt international: FR9701555
(87) Numéro de publication internationale: WO9811593

(56) Documents cités:
- EP-A- 0 538 938
- UHLEMANN S ET AL: "THE MANDOLINE FILTER - A NEW HIGH-PERFORMANCE IMAGING FILTER FOR SUB-EV EFTEM" OPTIK, vol. 96, no. 4, 1 juin 1994, pages 163-178, XP000454755 cité dans la demande

## Description

La présente invention concerne un filtre d'énergie, dit aussi filtre de vitesse, un microscope électronique à transmission et un procédé de filtrage d'énergie associé.

L'invention est surtout applicable aux microscopes électroniques à transmission ou TEM (Transmission Electron Microscope) ou aux microscopes mixtes TEM-STEM (Scanning Transmission Electron Microscope ou microscope électronique à balayage en transmission), ainsi qu'aux sources d'électrons. Il pourrait être utilisé pour les microscopes spécifiques STEM.

Un inconvénient notable des microscopes électroniques à transmission, dans la formation des images ou des diagrammes de diffraction, consiste en la présence d'aberrations chromatiques. Celles-ci, dues essentiellement aux imperfections des lentilles électromagnétiques ajustables du microscope, provoquent une détérioration du contraste et de la résolution. Les aberrations chromatiques peuvent être réduites dans une certaine mesure en appliquant une tension d'accélération des électrons à la fois élevée et stable, et en observant des échantillons très minces.

Cependant, une manière particulièrement efficace et précise d'améliorer l'image consiste à éliminer une partie des électrons dispersés de manière inélastique au moyen d'un filtre d'énergie.

On peut aussi utiliser les électrons ayant subi une perte d'énergie donnée pour former l'image. En sélectionnant une perte caractéristique d'un type d'interaction ou d'un élément chimique, on obtient alors une image filtrée donnant la répartition cartographique (mapping) de ce type d'interaction ou de cet élément.

Le filtrage d'énergie permet aussi de former l'image d'échantillons qui seraient trop épais pour être observés en microscopie électronique à transmission classique.

Un filtre d'énergie comporte traditionnellement des moyens de dispersion spatiale des électrons du faisceau transmis par l'échantillon en fonction de leur énergie, ainsi qu'une fente de filtrage permettant de sélectionner une fenêtre d'énergie. En plus de leur application au filtrage des images ou des diagrammes de diffraction, les filtres d'énergie sont également employés pour l'analyse spectrale de pertes d'énergie. Les filtres d'énergie peuvent être incorporés dans un microscope électronique soit à l'intérieur de la colonne du microscope comme partie intégrante de l'instrument, soit comme un accessoire sous l'écran de visualisation. On trouvera des exposés récents sur plusieurs types de filtres connus dans les articles de Bernard Jouffrey: « Energy loss spectroscopy for transmission electron microscopy » dans Electron Microscopy in Materials Science, World Scientific, 1991, pp. 363-368, et de Harald Rose et Dieter Krahl: «Electron optics of imaging energy filters », dans Energy Filtering Transmission Electron Microscopy, Springer, 1995, pp. 43-55.

Par exemple, l'article de la revue Optik, vol. 96, n° 4, pp. 163-178 d'Uhlemann et Rose décrit un filtre d'énergie magnétique du type mandoline.

Un paramètre déterminant des filtres d'énergie est la dispersion en énergie D, exprimée en µm/eV: plus ce paramètre est grand, plus le pouvoir sélectif du filtre est important. Pour augmenter cette dispersion D, divers filtres d'énergie ont été proposés, qui imposent aux électrons du faisceau de suivre un chemin optique suffisamment long. En effet, la dispersion D augmente en particulier avec la longueur du trajet effectué. Ainsi, dans les systèmes dits Ω tout en restant dans un plan vertical fixe, le faisceau se propageant selon l'axe optique du système est d'abord dévié latéralement, parcourt ensuite un chemin optique approximativement parallèle à l'axe optique dans le sens de propagation, puis est dévié vers l'axe optique du microscope pour être ramené en alignement avec sa direction initiale.

Le problème des filtres habituellement employés est leur encombrement. Une bonne dispersion D du filtre est en effet obtenue en faisant parcourir aux électrons un trajet sur une hauteur suffisamment grande. L'encombrement vertical des filtres existants est habituellement compris entre 25 et 50 cm, pour une dispersion D ne dépassant pas 6 µm/eV.

Dans la demande de brevet européen EP-0.538.938, il a été proposé un appareil à faisceau électronique muni d'un dispositif sélectif en énergie. Ce dernier fait suivre aux électrons une trajectoire dans un plan de dispersion ne contenant pas l'axe optique de l'appareil. L'encombrement vertical du dispositif sélectif en énergie est ainsi considérablement réduit pour une longueur donnée de trajet. Dans le mode particulier de réalisation exposé dans ce document (Figure 3), le filtre d'énergie comporte quatre éléments déviateurs de faisceau disposés dans le plan de dispersion, aux coins respectifs d'une figure approximativement rectangulaire qui admet deux plans de symétrie orthogonaux. Le filtre comprend également un premier élément déflecteur déviant le faisceau de l'axe optique du microscope vers l'un des éléments déviateurs dans le plan de dispersion, et un second élément déflecteur déviant le faisceau en provenance d'un autre des éléments déviateurs en alignement avec l'axe optique.

Le but de la présente invention est un filtre d'énergie capable de produire une grande dispersion D tout en ayant un faible encombrement vertical, améliorant notamment les propriétés de dispersion du filtre exposé dans le document EP-0.538.938.

Un autre but de l'invention est un tel filtre utilisable tant en microscopie électronique classique qu'à haute ou à basse tension, stigmatique au premier ordre et n'étant affecté que par de faibles aberrations.

Un but supplémentaire de l'invention est un filtre d'énergie autorisant des tensions d'accélération élevées.

L'invention a également pour objectif un microscope électronique à transmission équipé d'un filtre d'énergie produisant une grande dispersion D tout en ayant un encombrement vertical raisonnable, ce microscope pouvant être notamment du type TEM ou TEM-STEM.

L'invention vise aussi un procédé de filtrage d'énergie d'un faisceau électronique se propageant selon un axe optique, générant une grande dispersion sur une faible hauteur selon l'axe optique, ce procédé pouvant être appliqué à l'imagerie, la diffraction ou la spectrométrie.

A cet effet, l'invention concerne un filtre d'énergie recevant en fonctionnement un faisceau électronique orienté selon un axe optique dans un sens de propagation. Le filtre d'énergie comprend:
- un système déflecteur qui dévie suivant un trajet d'entrée dans un plan de dispersion n'incluant pas l'axe optique le faisceau reçu selon l'axe optique, et
- un système dispersif qui guide le faisceau envoyé par le système déflecteur sur un chemin optique inscrit dans le plan de dispersion et ramenant au système déflecteur suivant un trajet de sortie colinéaire au trajet d'entrée et qui génère une dispersion spatiale des électrons du faisceau en fonction de leur énergie,
le système déflecteur ramenant en alignement avec l'axe optique dans le sens de propagation le faisceau en provenance du système dispersif.

Selon l'invention, les trajets d'entrée et de sortie sont en sens opposés.

Le filtre d'énergie selon l'invention se distingue des systèmes existants en ce qu'il comprend un élément déflecteur unique qui, à la fois, dévie le faisceau dans un plan de dispersion n'incluant pas l'axe optique et assure des déviations inverses du faisceau à l'aller et au retour. Ce filtre d'énergie a ainsi un encombrement vertical considérablement réduit tout en étant particulièrement efficace, en permettant d'obtenir une grande dispersion, de faibles aberrations et d'autres propriétés optiques satisfaisantes.

Les termes « système déflecteur » et « système dispersif » sont des termes génériques qui réfèrent à l'effet technique principal de chacun des deux systèmes. Il est cependant difficilement évitable que le système déflecteur provoque également de la dispersion, même si celle-ci peut être réduite. De façon analogue, le système dispersif produit des déflexions du faisceau qui accompagnent la dispersion en énergie.

Les trajets aller et retour entre les systèmes déflecteur et dispersif sont d'une manière générale colinéaires, bien que de légers écarts puissent se produire entre eux.

Le filtre d'énergie peut ainsi fournir des résultats particulièrement satisfaisants, notamment quant à la dispersion D.

Il est avantageux que le système dispersif fasse décrire au faisceau électronique une courbe fermée n'entourant pas l'axe optique.

De cette manière, le chemin optique parcouru par le faisceau dans le plan de déflexion admet des changements de convexité favorables notamment à la limitation d'aberrations du second ordre.

Préférentiellement, les systèmes déflecteur et dispersif sont symétriques par rapport à un plan de symétrie contenant l'axe et par rapport au plan de dispersion.

Cette configuration des systèmes permet d'obtenir des propriétés correctes de stigmatisme et d'achromatisme.

Selon une forme de réalisation avantageuse du filtre d'énergie, le plan de dispersion est perpendiculaire à l'axe optique.

Dans un mode de réalisation préféré du système dispersif du filtre d'énergie selon l'invention, celui-ci comprend:
- un premier élément déviateur, qui reçoit le faisceau provenant du système déflecteur et le dévie selon une direction d'entrée, et
- un second élément déviateur, qui reçoit du premier élément déviateur le faisceau selon la direction d'entrée, lui fait subir un trajet circulaire dans le plan de dispersion et le renvoie vers le premier élément déviateur selon une direction de sortie,
le premier élément déviateur recevant le faisceau en provenance du second élément déviateur selon la direction de sortie et le déviant vers le système déflecteur.

Il est alors avantageux que le premier élément déviateur soit disposé entre l'axe et le second élément déviateur, le second élément comprenant une ouverture extérieure dans laquelle est partiellement disposé le premier élément.

Dans cette forme particulière, le système dispersif fait décrire au faisceau électronique une courbe fermée n'entourant pas l'axe optique.

Selon un mode de réalisation préféré de cette disposition:
- le premier élément déviateur est constitué par une paire de pièces polaires parallèles au plan de dispersion, ayant chacune une forme hexagonale comprenant une grande base perpendiculaire à l'axe en regard du système déflecteur, deux côtés perpendiculaires reliés à angle droit à la grande base et parallèles au plan de symétrie, deux côtés obliques respectivement reliés aux côtés perpendiculaires et une petite base opposée et parallèle à cette grande base et reliée aux côtés obliques, et
- le second élément déviateur est constitué par une paire de pièces polaires respectivement coplanaires avec les pièces polaires du premier élément, ayant chacune une forme de couronne comprenant un centre disposé dans le plan de symétrie, et dont l'ouverture extérieure débouche à l'intérieur de la couronne par un passage en regard de la petite base des pièces polaires du premier élément et est limitée latéralement par deux côtés respectivement en regard des côtés obliques des pièces polaires du premier élément.

Avantageusement, les systèmes déflecteur et dispersif comprenant des secteurs magnétiques qui comportent chacun une paire de pièces polaires en vis-à-vis séparées par un entrefer, reliées à des moyens d'activation et de contrôle qui créent dans chacun des entrefers un champ magnétique voulu, les champs magnétiques sont uniformes dans chaque entrefer.

L'invention a également pour objet un microscope électronique à transmission équipé d'un filtre d'énergie selon l'invention.

L'invention concerne aussi un procédé de filtrage d'énergie d'un faisceau électronique se propageant selon un axe optique dans un sens de propagation. Dans ce procédé:
- on guide le faisceau sur un chemin optique essentiellement inscrit dans un plan de dispersion n'incluant pas l'axe optique, de manière à générer une dispersion des électrons du faisceau en fonction de leur énergie, en faisant entrer le faisceau dans le plan de dispersion suivant un trajet d'entrée,
- on redirige le faisceau en alignement avec l'axe dans le sens de propagation, en faisant sortir le faisceau du plan de dispersion suivant un trajet de sortie colinéaire au trajet d'entrée, et
- on sélectionne spatialement une fenêtre d'énergie.

Selon l'invention, les trajets d'entrée et de sortie sont en sens opposés.

La présente invention sera mieux comprise à la lecture de la description qui suit d'un exemple de réalisation d'un microscope électronique et d'un filtre d'énergie selon l'invention, donné à titre indicatif et nullement limitatif, en référence aux dessins annexés, sur lesquels:
- La Figure 1 est une représentation schématique en coupe longitudinale d'un microscope électronique à transmission selon l'invention;
- La Figure 2 montre en perspective un filtre d'énergie selon l'invention employé dans le microscope électronique de la Figure 1;
- La Figure 3 est une vue de côté du filtre d'énergie de la Figure 2;
- La Figure 4 est une vue de dessus du filtre d'énergie de la Figure 2;
- La Figure 5 représente de manière schématique le chemin optique parcouru par le faisceau électronique dans le filtre d'énergie des Figures 2 à 4;
- Les Figures 6A et 6B représentent les trajectoires suivies par des électrons dans le filtre d'énergie des Figures 2 à 4, respectivement selon une première et une seconde section principale;
- La Figure 7A montre une courbe d'intensité I en fonction de la perte d'énergie E qui peut être obtenue pour un échantillon avec le microscope électronique de la Figure 1;
- La Figure 7B montre un agrandissement d'une partie de cette courbe, et
- La Figure 8 est une représentation schématique en coupe longitudinale d'une variante de réalisation du microscope électronique de la Figure 1.

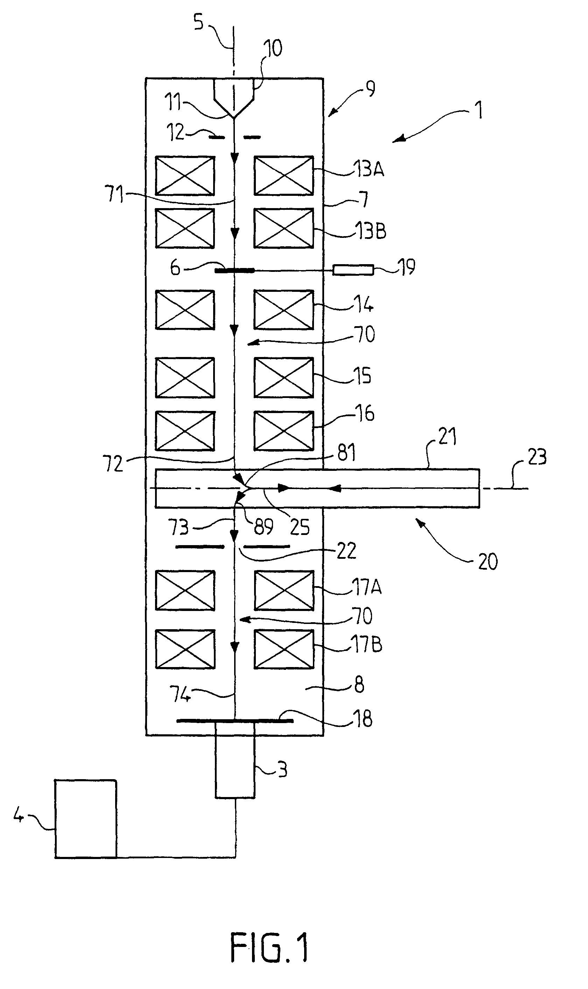

Un microscope électronique à transmission 1, tel que représenté sur la Figure 1, comprend classiquement une colonne 7 bâtie autour d'un axe optique 5, une unité d'acquisition 3, une unité de traitement 4, une pompe à vide et des moyens électroniques d'alimentation et de commande.

La colonne 7 du microscope 1 comprend en amont un canon à électron 9, comportant une source d'électrons 10, une cathode 11 et une anode 12. Une tension d'accélération V appliquée entre la cathode 11 et l'anode 12 permet d'extraire des électrons à une très grande vitesse. La tension de l'accélération V est classiquement comprise entre 80 kV et 300 kV, certains appareils travaillant à des tensions plus faibles ou plus élevées.

En supposant la colonne 7 verticale, les éléments suivants se succèdent du haut vers le bas de la colonne 7: un premier et un second systèmes de lentilles condenseur 13A et 13B, un porte-échantillon 19, un système de lentilles objectif 14, un système de lentilles de diffraction 15, un système de lentilles intermédiaires 16, un premier et un second systèmes de lentilles de projection 17A et 17B et un écran fluorescent 18 dans la partie inférieure de la colonne 7. Un tel montage est approprié à de l'imagerie, une image agrandie d'un échantillon 6 disposé sur le porte-échantillon 19 étant obtenue sur l'écran 18. Il est également adapté à la diffraction ou à l'obtention d'une sonde fine, fixe ou non.

L'ensemble des lentilles 13-17 sont des lentilles électromagnétiques à focale variable par variation de courant dans leur bobine d'alimentation. Les moyens électroniques alimentent les lentilles 13-17 pour qu'elles puissent focaliser ou dévier des rayons d'électrons, ainsi que le générateur de haute tension du canon 9 à électrons.

D'autres lentilles, non représentées par souci de clarté, peuvent être avantageusement rajoutées dans la colonne 7.

Un filtre d'énergie 20 est interposé entre les systèmes de lentilles 16 et 17A. Ce filtre 20 comporte des moyens de dispersion 21, qui dispersent spatialement les électrons d'un faisceau en fonction de leur énergie, et une fente 22 en aval des moyens de dispersion 21, qui sélectionne une fenêtre d'énergie dans le faisceau qui la traverse. Sur la Figure 1, la dispersion en énergie se produit essentiellement au premier ordre dans un plan perpendiculaire au plan de la feuille, la fente 22 étant ouverte dans une direction perpendiculaire au plan de la feuille. La fente 22 a préférentiellement une largeur et une position réglable, de façon à pouvoir ajuster la fenêtre d'énergie, tant en ce qui concerne l'énergie moyenne sur laquelle elle est centrée que sa largeur.

La partie inférieure de la colonne 7 forme une chambre 8 de projection.

Classiquement, il est nécessaire d'imposer un vide élevé au sein de la colonne 7 et du filtre 20 d'énergie, ce vide étant typiquement de l'ordre de 2,5 · 10⁻⁵ Pa.

L'unité de traitement 3, reliée à l'écran 18, permet d'obtenir des informations précises sur l'image formée sur cet écran 18. Le microscope permet de mesurer l'intensité I reçue par l'écran 18 pour une perte d'énergie E donnée d'un faisceau d'électrons, et de visualiser et stocker un spectre correspondant, au moyen de l'unité de traitement 3. Le filtre 20 d'énergie du microscope électronique 1 de l'exemple peut donc avoir une double application: filtrage de l'image formée sur l'écran 18, ou analyse de l'échantillon 6 par obtention d'un spectre de perte d'énergie.

En fonctionnement, l'échantillon 6 convenablement préparé est disposé sur le porte-échantillon 19. Un faisceau 70 d'électrons, envoyés par le canon 9 à électrons selon l'axe optique 5 parvient à l'échantillon 6 sous la forme d'un faisceau incident 72 après son passage par les systèmes de lentilles condenseur 13A et 13B. Il traverse l'échantillon 6 et devient un faisceau transmis 72 qui passe par les systèmes de lentilles objectif 14, de diffraction 15 et intermédiaires 16, et est soumis à une dispersion d'énergie dans les moyens de dispersion 21. Le faisceau 70 prend ainsi la forme d'un faisceau dispersé 73 en sortie des moyens de dispersion 21, ce faisceau dispersé 73 étant aligné avec l'axe optique 5. Il est ensuite filtré en passant par la fente 22 et ce faisceau filtré 74, après son passage par les systèmes de lentilles de projection 17A et 17B, parvient à l'écran 18. On obtient ainsi une image ou un diagramme de diffraction filtré, ou un spectre de perte d'énergie d'une plage de l'échantillon 6 plus ou moins grande.

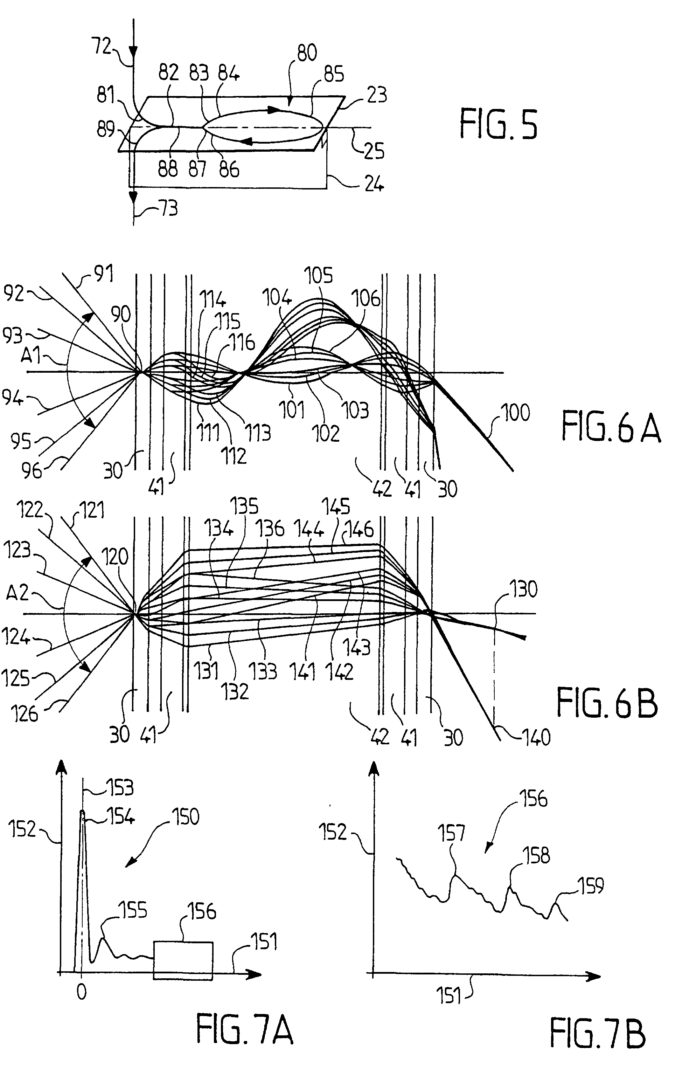

Le spectre est représenté sous la forme d'une courbe 150 d'intensité I en fonction de la perte d'énergie E, comme on peut le voir sur la Figure 7A, la perte d'énergie E et l'intensité I étant respectivement associés aux axes 151 et 152. Dans le cas d'un objet mince, on observe un pic sans perte 154 élevé centré sur l'axe 153 de perte nulle, la plupart des électrons étant transmis par l'échantillon 6 sans perte d'énergie E, par interaction élastique avec des noyaux atomiques. Le pic sans perte 154 est généralement suivi par un ou plusieurs pics secondaires 155, leurs hauteurs dépendant de l'épaisseur de l'échantillon 6, puis par des fluctuations admettant des extrema successifs et diminuant progressivement en intensité l. Les extrema 157-159 de la courbe 150 (figure 7B) peuvent avoir des intensités I inférieures à celle du pic principal 154 de plusieurs ordres de grandeurs et ne sont donc visibles qu'au prix d'un comptage plus long permettant d'accumuler les électrons dans une fenêtre d'énergie 156 déterminée.

Les moyens de dispersion 21 vont maintenant être décrits plus en détail dans leur structure et leur fonction. Ceux-ci sont essentiellement disposés selon un plan de dispersion 23 perpendiculaire à l'axe optique 5 et donc horizontal. L'ensemble des éléments de ces moyens de dispersion 21 sont symétriques par rapport à ce plan de dispersion 23. Ils sont également symétriques par rapport à un plan de symétrie 24 contenant l'axe optique 5 (Figure 5).

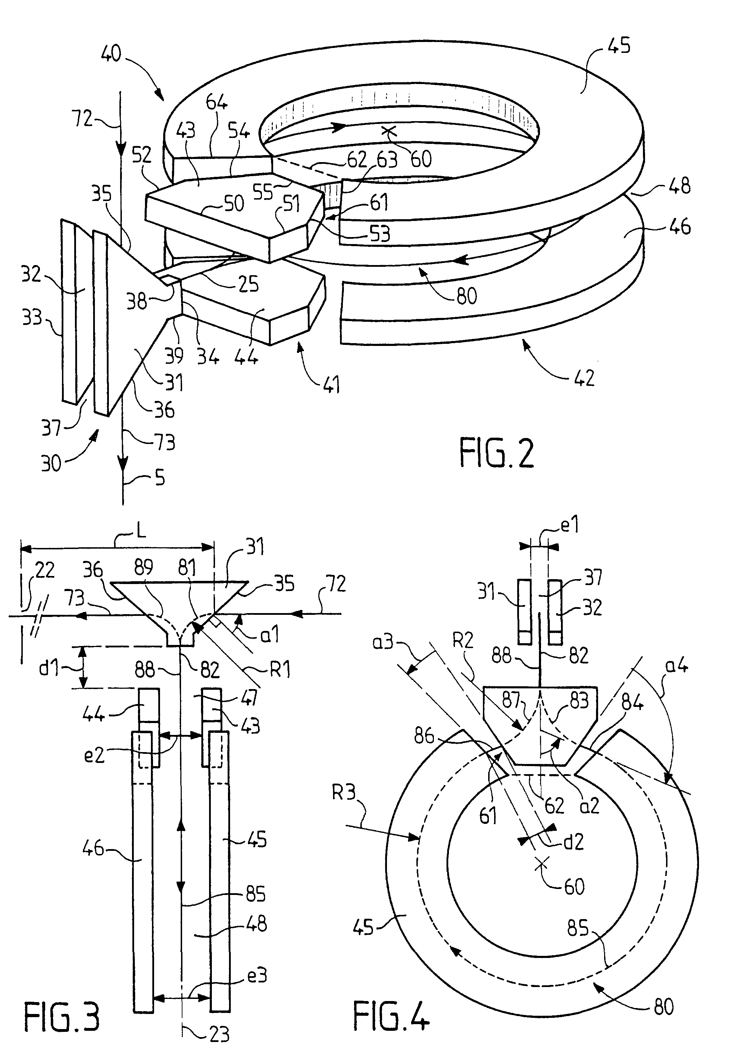

Les moyens de dispersion 21, représentés sur les Figures 2 à 4, comprennent un système déflecteur 30 et un système dispersif 40. Le système déflecteur 30 exerce une double fonction: il dévie dans le plan de dispersion 23 le faisceau transmis 72 selon l'axe optique 5 en direction du système dispersif 40, et il redévie en alignement avec l'axe optique 5 dans le sens initial de propagation le faisceau 70 en provenance du système dispersif 40. Le système déflecteur 30 constitue ainsi une interface entre l'axe optique et le plan de dispersion 23 en ce qui concerne le parcours suivi par le faisceau 70.

Le système dispersif 40 guide quant à lui le faisceau 70 envoyé par le système déflecteur 30, sur un chemin optique 80 inscrit dans le plan de dispersion 23, et le renvoie vers le système déflecteur 30. Le système dispersif 40 comporte un premier et un second éléments déviateurs 41 et 42, recevant successivement le faisceau 70 en provenance du système déflecteur 30.

Le système déflecteur 30 et les deux éléments déviateurs 41 et 42 constituent respectivement trois secteurs magnétiques des moyens de dispersion 21.

Dans l'exemple particulier de réalisation présenté, le système déflecteur 30 comprend deux pièces polaires ou électro-aimants 31 et 32 parallèles au plan de symétrie 24. Chacune des pièces 31 et 32 a une forme approximativement triangulaire, comportant une grande base 33 et deux côtés obliques supérieur 35 et inférieur 36. Cette forme triangulaire est prolongée au niveau du sommet opposé à la grande base 33, par une protubérance rectangulaire comprenant une petite base 34 parallèle et opposée à la grande base 33 et deux côtés 38 et 39 perpendiculaires à la petite base 34 et la reliant respectivement aux côtés obliques 35 et 36. Les bases 33 et 34 sont parallèles à l'axe 5 et disposées de part et d'autre de cet axe 5.

Le premier élément déviateur 41 comprend deux pièces polaires 43 et 44 parallèles au plan de dispersion 23. Chacune d'entre elles a une forme hexagonale, comprenant une grande base 50 perpendiculaire à l'axe 5, en regard des petites bases 34 des pièces polaires 31 et 32. Elle comporte également deux côtés perpendiculaires 51 et 52 reliés à angle droit à la grande base 50 et parallèles au plan de symétrie 24, deux côtés obliques 53 et 54 respectivement reliés aux côtés perpendiculaires 51 et 52 et une petite base 55 opposée et parallèle à la grande base 50 et reliée aux côtés obliques 53 et 54. Les pièces polaires supérieure 43 et inférieure 44 sont séparées par un entrefer 47.

Le second élément déviateur 42 comprend quant à lui deux pièces polaires supérieure 45 et inférieure 46 respectivement coplanaires avec les pièces polaires 43 et 44 du premier élément déviateur 41. Le premier élément 41 est disposé entre l'axe 5 et le second élément 42, et les pièces polaires 45 et 46 de ce dernier comprennent des ouvertures extérieures 61 dans lesquelles sont respectivement disposées les pièces polaires 43 et 44 du premier élément 41, de façon partielle. Chacune des pièces polaires 45 et 46 a une forme de couronne ouverte comprenant un centre 60 disposé dans le plan de symétrie 24. Son ouverture extérieure 61 débouche à l'intérieur de la couronne par un passage 62 faisant face aux petites bases 55 et est limitée latéralement par deux côtés 63 et 64 respectivement en regard des côtés obliques 53 et 54 de la pièce polaire 43, 44 correspondante. Les pièces polaires 45 et 46 sont séparées par un entrefer 48. La forme de couronne des pièces polaires 45 et 46 permet d'obtenir une structure légère et une bonne répartition du champ magnétique.

En fonctionnement, les moyens électroniques appliquent dans chacun des entrefers 37, 47, 48 des secteurs magnétiques 30, 41, 42 un champ magnétique constant et préférentiellement uniforme. Le faisceau 72 transmis par l'échantillon 6 parvient au système déflecteur 30 selon l'axe optique 5. Il est alors dévié entre les pièces polaires 31 et 32 de manière à s'inscrire dans le plan de dispersion 23, en suivant un arc de cercle 81 d'entrée de rayon R1. Le faisceau 70 parcourt ensuite l'espace libre entre le système déflecteur 30 et le premier élément déviateur 41, selon un segment d'entrée 82 à l'intersection des plans de dispersion 23 et de symétrie 24, le segment d'entrée 82 définissant une direction 25 de déflexion. L'ensemble du chemin optique parcouru ensuite par le faisceau 70 jusqu'à son retour au système déflecteur 30 est inclus dans le plan de dispersion 23.

Le faisceau 70 parvient après le segment 82 d'entrée au premier élément déviateur 41, et y décrit un arc de cercle 83 intérieur au système dispersif 40, de rayon R2. Le faisceau 70 sort du premier élément 41 par l'un des côtés obliques 54 selon une direction formant avec ce côté un angle a4. Il parcourt ensuite entre le côté oblique 54 et le second élément déviateur 42 un premier segment 84 intérieur au système dispersif 40.

Le faisceau 70 pénètre ensuite dans le second élément déviateur 42 par le côté 64 de l'ouverture 61 faisant face au côté oblique 54 et y décrit un parcours circulaire 85 centré sur le centre 60 et de rayon R3.

La suite du trajet suivi par le faisceau 70 obéit à la symétrie par rapport au plan de symétrie 24. Ainsi, le chemin optique suivi par le faisceau 70 comprend successivement un second segment intérieur 86 entre le côté 63 du second élément 42 et le côté oblique 53 du premier élément 41, un arc de cercle intérieur 87 au sein du premier élément 41, et un segment 88 de sortie, confondu avec le segment 82 d'entrée.

Parvenu au système déflecteur 30, le faisceau 70 est redévié vers l'axe 5 dans le sens de propagation initial, parcourant dans le système déflecteur 30 un arc de cercle 89 de sortie symétrique à celui 81 d'entrée par rapport au plan de dispersion 23. Il ressort ainsi en alignement avec l'axe 5, sous la forme du faisceau dispersé 73.

L'ensemble des portions de trajectoire 81-89 suivies par le faisceau 70 constitue le chemin optique 80 parcouru dans les moyens de dispersion 21. Ce chemin optique 80 comporte essentiellement une courbe fermée 83-87 n'incluant pas l'axe optique 5, une portion linéaire 82 et 88 entre l'axe 5 et cette courbe fermée et des connexions 81, 89 de cette portion linéaire à l'axe 5. Les changements de courbure dans la courbe fermée, c'est-à-dire les passages entre arcs de cercle 83 et 85 d'une part, et 85 et 87 d'autre part, ont un effet positif sur la diminution des aberrations du second ordre.

La disposition des segments 82 et 88 d'entrée et de sortie s'avère procurer des propriétés optiques très satisfaisantes, notamment une bonne dispersion D, sous réserve d'un choix satisfaisant des paramètres du filtre 20

Les propriétés optiques du filtre 20 dépendent principalement de neuf paramètres: les trois rayons R1, R2 et R3; la distance d1 entre le système déflecteur 30 et le premier élément fléchissant 41, et la distance d2 parcourue par le faisceau 70 entre le premier élément fléchissant 41 et le second élément fléchissant 42; l'angle a1 défini pour le système déflecteur 30 entre la normale au côté oblique supérieur 35 et le faisceau transmis 72, l'angle a2 défini pour le premier élément fléchissant 41 comme l'angle de déflexion de cet élément, l'angle a3 entre l'un des côtés obliques 53, 54 du premier élément fléchissant 42 et le côté 63, 64 du second élément fléchissant 42, et l'angle a4.

Un choix particulièrement judicieux de ces paramètres du filtre 20 est:
R1 = 2,70 cm, R2 = 5,40 cm, R3 = 9,98 cm; d1 = 3,51 cm, d2 = 1,35 cm;
a1 = 45,5°, a2 = 64,5°, a3 = 10°, a4 = 81,4°.

D'autres paramètres rentrant en jeu sont les largeurs e1, e2 et e3 respectives des entrefers 37, 47 et 48. Ces largeurs e1, e2, e3 sont choisies de manière à faire un compromis entre des besoins opposés: plus elles sont petites, moins le champ de fuite est important, donc moins les aberrations sont élevées, mais plus on est gêné pour l'ouverture du faisceau 70, notamment en mode de diffraction. Les largeurs e1, e2 et e3 sont traditionnellement comprises entre 2 et 10 mm, étant avantageusement de l'ordre de 2 mm.

On définit la longueur L comme la distance entre le point d'entrée du faisceau transmis 72 dans le système déflecteur 30 et la position de la fente 22 de sélection. A titre d'illustration, la dispersion D vaut respectivement 6 µm/eV, 8 µm/eV et 10 µm/eV pour les longueurs L respectivement égales à 18,7 cm, 23,9 cm et 29 cm.

La dispersion en énergie du faisceau 72 transmis par l'échantillon 6 peut être matérialisée en considérant diverses trajectoires d'électrons, comme représenté sur les Figures 6A et 6B. Dans cet exemple, les largeurs e1, e2 et e3 des entrefers 37, 47 et 48 sont égales à 6,5 mm, la tension d'accélération V vaut 200 kV et la dispersion vaut 8 µm/eV. Le faisceau 72 reçu par le filtre 20 a une divergence de 15 mrad.

On s'intéresse aux projections de certaines trajectoires du faisceau 70 selon deux sections principales. La première section principale est associée au suivi du faisceau 70 dans le plan de dispersion 23, tandis que la seconde correspond au suivi du faisceau 70 dans un plan perpendiculaire au plan de dispersion 23. Les espaces et les angles sont fortement accentués sur les Figures 6A et 6B à seules fins de clarté. Pour simplifier, on suppose que deux familles d'électrons parviennent au filtre 20, chacune correspondant à une perte d'énergie définie. Ces pertes valent respectivement 340 eV et 2400 eV.

Dans la première section principale (Figures 6A), les électrons représentés parviennent au système déflecteur 30 selon six directions 91-96 distinctes. Les directions 91-96 ont une ouverture angulaire A1 égale à la divergence du faisceau valant 15 mrad, et à chaque direction incidente correspondent deux trajectoires d'électrons appartenant respectivement aux deux familles. Les trajectoires se croisent en un point d'entrée 90 situé dans le système déflecteur 30, ce point d'entrée 90 étant le point de première convergence ou cross-over d'entrée. Les trajectoires selon les deux familles superposées en entrée, se dissocient alors pour former six trajectoires 101-106 pour les électrons de la première famille et six autres trajectoires 111-116 pour les électrons de la seconde famille. Après avoir traversé successivement le système déflecteur 30, le premier élément déviateur 41, le second élément déviateur 42, puis de nouveau le premier élément déviateur 41, les trajectoires des électrons traversent une nouvelle fois le système déflecteur 30 et les trajectoires 101-106 et 111-116 des deux familles se rejoignent pour se croiser respectivement en un premier point 100 et en un second point non représenté, à la verticale du premier point 100, ces points étant appelés cross-over de sortie et situés à la sortie du système déflecteur 30.

Un comportement analogue est observé dans la seconde section principale (Figure 6B). Ainsi, les électrons du faisceau 72 parviennent au système déflecteur 30 selon six directions 121-126 d'ouverture angulaire A2 égale à l'ouverture du faisceau 72, qui vaut 15 mrad. Les trajectoires d'électrons se rejoignent en un point d'entrée 120 de première convergence, puis les deux familles d'énergie superposées en entrée pour chaque trajectoire se dissocient, générant ainsi six trajectoires d'électrons 131-136 pour la première famille et six autres 141-146 pour la seconde famille. Les trajectoires 131-136 et 141-146 parcourent successivement le système déflecteur 30, le premier élément déviateur 41, le second élément fléchissant 141, de nouveau le premier élément déviateur 41, puis le système déflecteur 30, et elles convergent ensuite en deux points 130 et 140 à la verticale l'un de l'autre, images du point d'entrée 120 respectivement pour les deux familles.

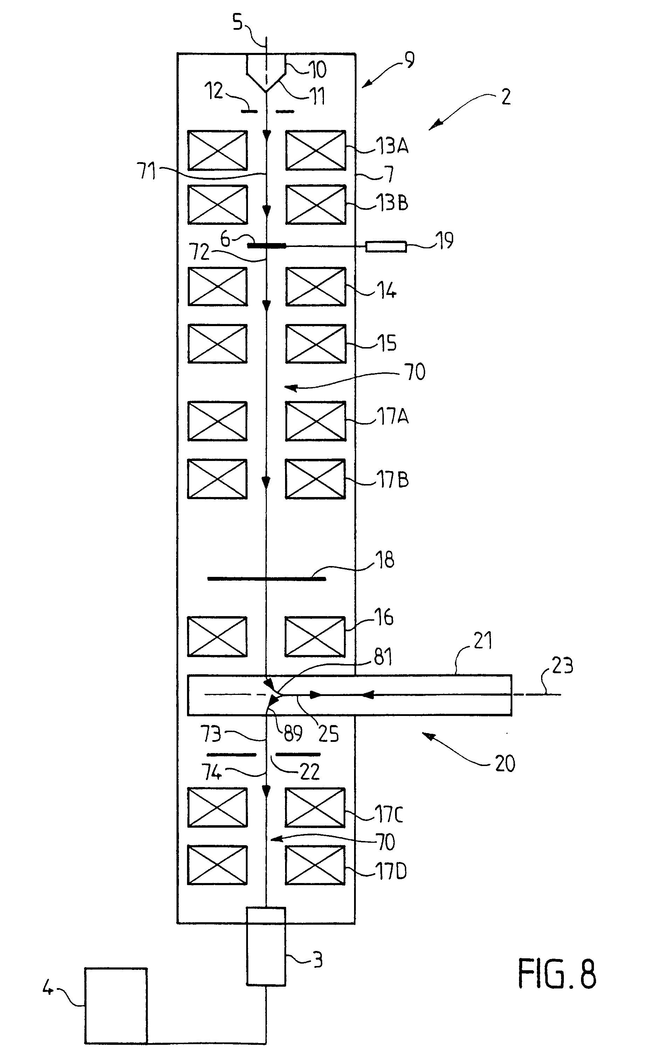

Dans une variante de mise en oeuvre du filtre d'énergie selon l'invention, représentée sur la Figure 8, le filtre 20 est disposé dans la partie inférieure de la colonne 7 d'un microscope 2. Sur la Figure 8, les éléments identiques à ceux de la Figure 1 sont désignés par les mêmes références.

Dans cette configuration, les éléments suivants se succèdent du haut vers le bas de la colonne 7: les systèmes de lentilles condenseur 13A et 13B, le porte-échantillon 19, le système de lentilles objectif 14, le système de lentilles de diffraction 15, le premier et le second systèmes de lentilles de projection 17A et 17B, l'écran 18, le système de lentilles intermédiaires 16, le filtre 20, et un troisième et quatrième systèmes de lentilles de projection 17C et 17D. L'unité d'acquisition 3 est placée en aval de la colonne 7 et est reliée à l'unité de traitement 4. Un avantage de ce mode de réalisation du microscope 2 est que le dispositif avec filtre 20 peut être simplement rajouté au-dessous d'un microscope existant.

Parmi les variantes intéressantes restant dans le cadre de l'invention, le champ magnétique appliqué entre les prismes supérieur 45 et inférieur 46 du second élément déviateur 42 peut ne pas être uniforme, mais admettre un gradient constant. Ce gradient est appliqué de façon à focaliser le faisceau 70 entre les prismes 45 et 46, de manière à réduire les collisions d'électrons sur les pièces polaires et à diminuer ainsi les pertes du faisceau 70.

Il est bien entendu que les formes particulières données aux systèmes déflecteur et dispersif ne constituent qu'un mode particulier de réalisation et que toute autre mise en oeuvre est possible du moment qu'elle est couverte par le champ de revendications. Notamment, le système dispersif 40 peut être tel qu'il fait décrire au faisceau électronique 70 une courbe fermée entourant l'axe optique 5. Pour ce faire, le système dispersif 40 est par exemple constitué de deux éléments déviateurs dont l'un est situé d'un premier côté de l'axe optique et l'autre du côté opposé, le premier élément déviateur déviant les électrons vers le second élément déviateur, qui leur fait parcourir un chemin optique d'une longueur suffisante pour obtenir la dispersion D voulue.

La description d'une courbe fermée entourant l'axe optique 5 permet de réduire la place nécessaire pour l'ensemble des moyens de dispersion 21, mais a l'inconvénient d'augmenter les aberrations du second ordre car la trajectoire dans le plan de dispersion 23 est toujours décrite dans le même sens.

Conformément au mode de réalisation exposé, le système déflecteur 30 reçoit le faisceau transmis 72 selon l'angle d'incidence a1, préférentiellement égal à 45,5°. D'autres formes que celle présentée peuvent convenir, si elles offrent ce même angle d'incidence a1.

Cependant, le système déflecteur 30 peut aussi être constitué de pièces polaires 31 et 32 recevant le faisceau transmis 72 à incidence normale. Dans ce cas, on place un système optique multipolaire en entrée du système déflecteur 30, tel qu'un quadripôle ou un octopôle.

D'une manière générale, les systèmes déflecteur 30 et dispersif 40 doivent être conçus de manière à ce que les propagations du faisceau 70 entre l'un et l'autre soient colinéaires, ou à ce que le système déflecteur soit formé d'un élément déflecteur unique.

Bien que la présentation de l'invention ait été faite pour un microscopique électronique à transmission ou TEM, elle est également valable pour un microscope électronique à balayage en transmission ou STEM ou pour un microscope électronique mixte.

## Revendications

1. Filtre d'énergie (20) recevant en fonctionnement un faisceau électronique (70) orienté selon un axe optique (5) dans un sens de propagation, comprenant:
- un système déflecteur (30) qui dévie suivant un trajet d'entrée (82) dans un plan de dispersion (23) n'incluant pas l'axe optique (5) le faisceau reçu (72) selon l'axe optique (5), et
- un système dispersif (40) qui guide le faisceau (70) envoyé par le système déflecteur (30) sur un chemin optique (80) inscrit dans le plan de dispersion (23) et ramenant au système déflecteur (30) suivant un trajet de sortie (88) colinéaire au trajet d'entrée (82) et qui génère une dispersion spatiale des électrons du faisceau (73) en fonction de leur énergie,
le système déflecteur (30) ramenant en alignement avec l'axe optique (5) dans le sens de propagation le faisceau (70) en provenance du système dispersif (40),
caractérisé en ce que les trajets d'entrée (82) et de sortie (88) sont en sens opposés.

2. Filtre d'énergie (20) selon la revendication 1, caractérisé en ce que le système dispersif (40) fait décrire au faisceau électronique (70) une courbe fermée (83-87) n'entourant pas l'axe optique (5).

3. Filtre d'énergie (20) selon l'une quelconque des revendications précédentes, caractérisé en ce que les systèmes déflecteur (30) et dispersif (40) sont symétriques par rapport à un plan de symétrie (24) contenant l'axe (5) et par rapport au plan de dispersion (23).

4. Filtre d'énergie (20) selon l'une quelconque des revendications précédentes, caractérisé en ce que le plan de dispersion (23) est perpendiculaire à l'axe optique (5).

5. Filtre d'énergie (20) selon l'une quelconque des revendications précédentes, caractérisé en ce que le système dispersif (40) comprend:
- un premier élément déviateur (41), qui reçoit le faisceau (70) provenant du système déflecteur (30) et le dévie selon une direction d'entrée (84), et
- un second élément déviateur (42), qui reçoit du premier élément déviateur (41) le faisceau (70) selon la direction d'entrée (84), lui fait subir un trajet circulaire (85) dans le plan de dispersion(23) et le renvoie vers le premier élément déviateur (41) selon une direction de sortie (86),
le premier élément déviateur (41) recevant le faisceau (70) en provenance du second élément déviateur (42) selon la direction de sortie (86) et le déviant vers le système déflecteur (30).

6. Filtre d'énergie (20) selon la revendication 5, caractérisé en ce que le premier élément déviateur (41) est disposé entre l'axe (5) et le second élément déviateur (42), le second élément (42) comprenant une ouverture extérieure (61) dans laquelle est partiellement disposé le premier élément (41).

7. Filtre d'énergie (20) selon les revendications 3 et 6, caractérisé en ce que:
- le premier élément déviateur (41) est constitué par une paire de pièces polaires (43, 44) parallèles au plan de dispersion (23), ayant chacune une forme hexagonale comprenant une grande base (50) perpendiculaire à l'axe (5) en regard du système déflecteur (30), deux côtés perpendiculaires (51, 52) reliés à angle droit à la grande base (50) et parallèles au plan de symétrie (24), deux côtés obliques (53, 54) respectivement reliés aux côtés perpendiculaires (51, 52) et une petite base (55) opposée et parallèle à ladite grande base (50) et reliée aux côtés obliques (53, 54), et
- le second élément déviateur (42) est constitué par une paire de pièces polaires (45, 46) respectivement coplanaires avec les pièces polaires (43, 44) du premier élément (41), ayant chacune une forme de couronne comprenant un centre (60) disposé dans le plan de symétrie (24), et dont ladite ouverture extérieure (61) débouche à l'intérieur de la couronne par un passage (62) en regard de la petite basé (55) des pièces polaires (43, 44) du premier élément (41) et est limitée latéralement par deux côtés (63, 64) respectivement en regard des côtés obliques (53, 54) des pièces polaires (43, 44) du premier élément (41).

8. Filtre d'énergie (20) selon l'une quelconque des revendications précédentes, caractérisé en ce que les systèmes déflecteur (30) et dispersif (40) comprenant des secteurs magnétiques (30, 41, 42) qui comportent chacun une paire de pièces polaires (31, 32, 43-46) en vis-à-vis séparés par un entrefer (37, 47, 48), reliées à des moyens d'activation et de contrôle qui créent dans chacun des entrefers (37, 47, 48) un champ magnétique voulu, lesdits champs magnétiques sont uniformes dans chaque entrefer (37, 47, 48).

9. Microscope électronique à transmission (1) équipé d'un filtre d'énergie (20) conforme à l'une quelconque des revendications 1 à 8.

10. Procédé de filtrage d'énergie d'un faisceau électronique (70) se propageant selon un axe optique (5) dans un sens de propagation dans lequel:
- on guide le faisceau (72) sur un chemin optique (80) essentiellement inscrit dans un plan de dispersion (23) n'incluant pas l'axe optique (5), de manière à générer une dispersion des électrons du faisceau (73) en fonction de leur énergie, en faisant entrer le faisceau (72) dans le plan de dispersion (23) suivant un trajet d'entrée (82),
- on redirige le faisceau (73) en alignement avec l'axe (5) dans le sens de propagation, en faisant sortir le faisceau (73) du plan- de dispersion (23) suivant un trajet de sortie (88) colinéaire au trajet d'entrée (82), et
- on sélectionne spatialement une fenêtre d'énergie (22),
caractérisé en ce que les trajets d'entrée (82) et de sortie (88) sont en sens opposés.

## Claims

1. An energy filter (20) receiving during operation an electron beam (70) oriented along an optical axis (5) in a propagation direction comprising:
- a deflecting system (30) that deviates according to an input path (82) in a dispersion plane (23) not containing the optical axis (5), the beam (72) received along the optical axis (5), and
- a dispersing system (40) that guides the beam (70) sent from the deflecting system (30) on an optical path (80) inscribed in the dispersion plane (23) and returning to the deflecting system (30) according to an output path (88) colinear to the input path (82) and which generates a spatial dispersion of the electrons of the beam (73) in relation to their energy,
whereby the deflecting system (30) brings back in alignment with the optical axis (5) in the propagation direction the beam (70) coming from the dispersing system (40),
caracterised in that the input (82) and output (88) paths are in opposite directions.

2. An energy filter (20) according to claim 1, characterised in that the dispersing system (40) causes the electron beam (70) to describe a closed curve (83-87) not surrounding the optical axis (5).

3. An energy filter (20) according to any one of the previous claims, characterised in that the deflecting (30) and dispersing (40) systems are symmetrical with respect to a plane of symmetry (24) containing the axis (5) and with respect to the dispersion plane (23).

4. An energy filter (20) according to any one of the previous claims, characterised in that the dispersion plane (23) is perpendicular to the optical axis (5).

5. An energy filter (20) according to any one of the previous claims, characterised in that the dispersing system (40) comprises:
- a first deviating element (41), which receives the beam (70) coming from the deflecting system (30) and which deviates the latter along an input direction (84), and
- a second deviating element (42) which receives from the first deviating element (41) the beam (70) along the input direction (84), causes it to follow a circular path (85) in the dispersion plane (23) and sends it back towards the first deviating element (41) along an output direction (86),
whereas the first deviating element (41) receives the beam (70) coming from the second deviating element (42) along the output direction (86) and deviates it towards the deflecting system (30).

6. An energy filter (20) according to claim 5, characterised in that the first deviating element (41) is arranged between the axis (5) and the second element deviating element (42), whereas the second element (42) comprises an external aperture (61) in which the first element (41) is installed partially.

7. An energy filter (20) according to claims 3 and 6, characterised in that:
- the first element (41) comprises a pair of polar parts (43, 44) parallel to the dispersion plane (23), each being hexagonal in shape and comprising a larger base (50) perpendicular to the axis (5) facing the deflecting system (30), two perpendicular sides (51, 52) connected at right angle to the larger base (50) and parallel to the plane of symmetry (24), two oblique sides (53, 54), respectively connected to the perpendicular sides (51, 52) and a smaller base (55) opposite and parallel to the said larger base (50) and connected to both oblique sides (53, 54), and
- the second element (42) comprises a pair of polar parts (45 46), respectively coplanar with the polar parts (43, 44) of the first element (41), each crown-shaped, comprising a centre (60) arranged in the plane of symmetry (24) and whose external aperture (61) reaches inside the crown through a passage (62) facing the smaller (55) of the polar parts (43, 44) of the first element (41) and is delineated laterally by two sides (63, 64), respectively facing the oblique sides (53, 54) of the polar parts (43, 44) of the first element (41).

8. An energy filter (20) according to any one of the previous claims, characterised in that the deflecting (30) and dispersing (40) systems comprise magnetic sectors (30, 41, 42) which comprise, each a pair of opposite polar parts (31, 32, 43-46), separated by an air-gap (37, 47, 48), connected to actuation and control means in order to create in each air-gap (37, 47, 48); a requested magnetic field, whereby the magnetic fields are uniform in each air-gap (37, 47, 48).

9. A transmission electron microscope (1) provides with an energy filter (20) according to any one of claims 1 to 8.

10. A method of energy filtering of an electron beam (70) propagating along an optical axis (5) in a propagation direction in which:
- the beam (72) is guided on an optical path (80) substantially inscribed in a dispersion plane (23) not including the optical axis (5) in order to generate dispersion of the electrons of the beam (73) in relation to their energy by the input of the beam (72) in the dispersion plane (23) according to an input path (82),
- the beam (73) is re-directed in alignment with the axis (5) in the propagation direction, by the output of the beam (73) in the dispersion plane (23) according to an output path (88) colinear to the input path (82), and
- an energy window (22) is selected spatially,
characterised in that the input (82) and output (88) paths are in opposite directions.

## Patentansprüche

1. Energiefilter (20), das im Betrieb einen entlang einer optischen Achse (5) in einer Ausbreitungsrichtung ausgerichteten Elektronenstrahl (70) empfängt, umfassend:
- ein Ablenkungssystem (30), welches den entlang der optischen Achse (5) empfangenen Strahl (72) gemäß einer Eintrittsstrecke (82) in eine die optische Achse (5) nicht einschließende Streuungsebene (23) ablenkt, und
- ein Streuungssystem (40), welches den vom Ablenkungssystem (30) geführten Strahl (70) auf einen in der Streuungsebene (23) liegenden optischen Weg (80) führt und entlang einer zur Eintrittstrecke (82) kolinear verlaufenden Austrittsstrecke (88) zum Ablenkungssystem (30) zurückführt, das eine räumliche Streuung der Elektronen des Strahls (73) gemäß ihrer Energie erzeugt, wobei das Ablenkungssystem (30) den vom Streuungssystem (40) kommenden Strahl (70) in Ausbreitungsrichtung mit der optischen Achse (5) wieder in Ausrichtung bringt,
dadurch gekennzeichnet, daß die Eintrittsstrecke (82) und die Austrittsstrecke (88) in entgegengesetzter Richtung verlaufen.

2. Energiefilter (20) nach Anspruch 1, dadurch gekennzeichnet, daß das Streuungssystem (40), den Elektronenstrahl (70) eine geschlossene Kurve (83 - 87) beschreiben läßt, welche die optische Achse (5) nicht umgibt.

3. Energiefilter (20) nach einem der vorstehenden Ansprüche, dadurch gekennzeichnet, daß das Ablenkungssystem (30) und das Streuungssystem (40) in Bezug auf eine Symmetrieebene (24), welche die Achse (5) enthält, und in Bezug auf die Streuungsebene (23) symmetrisch sind.

4. Energiefilter (20) nach einem der vorstehenden den Ansprüche, dadurch gekennzeichnet, dass die Streuungsebene (23) senkrecht zu der optischen Achse (5) verläuft.

5. Energiefilter (20) nach einem der vorstehenden Ansprüche, dadurch gekennzeichnet, dass das Streuungssystem (40) umfaßt:
- ein erstes Ablenkungselement (41), weiches den Strahl (70), der von dem Ablenkungssystem (30) kommt, empfängt und entlang einer Eintrittsrichtung (84) ablenkt, und
- ein zweites Ablenkungselement (42), welches den Strahl (70) entlang der Eintrittsrichtung (84) von dem ersten Ablenkungselement (41) empfängt und einen kreisförmigen Weg (65) in der Streuungsebene (23) durchführen läßt und entlang einer Austrittsrichtung (86) zu dem ersten Ablenkungselement (41) zurückschickt, wobei das erste Ablenkungselement (41) den Strahl (70), der vom zweiten Ablenkungselement (42) kommt, entlang der Austrittsrichtung (86) empfängt und zu dem Ablenkungssystem (30) hin ablenkt.

6. Energiefilter (20) nach Anspruch 5, dadurch gekennzeichnet, daß das erste Ablenkungselement (41) zwischen der Achse (5) und dem zweiten Ablenkungselement (42) angeordnet ist, wobei das zweite Element (42) eine äußere Öffnung (61) aufweist, in der das erste Element (41) teilweise angeordnet ist.

7. Energiefilter (20) nach den Ansprüchen 3 und 6, dadurch gekennzeichnet, daß:
- das erste Ablenkungselement (41) aus einem Paar polarer Teile (43, 44) besteht, die parallel zu der Streuungsebene (23) verlaufen, wobei jeder Teil eine hexagonale Form aufweist, welche eine große Basis (50) senkrecht zu der Achse (5) gegenüberliegend von dem Ablenkungssystem (30), zwei senkrechte Seiten (51, 52), die im rechten Winkel mit der großen Basis (50) verbunden und parallel zu der Symmetrieebene (24) ) verlaufen, zwei schräge Seiten (53, 54), die jeweils mit den senkrechten Seiten (51, 52) verbunden sind, und eine kleine Basis (55) umfaßt, die zu der großen Basis (50) gegenüberliegend und parallel und mit den schrägen Seiten (53, 54) verbunden ist, und
- das zweite Ablenkungselement (42) aus einem Paar polarer Teile (45, 46) besteht, die jeweils koplanar mit zu polaren Teilen (43,44) des ersten Elements (41) verlaufen, wobei jedes Tell eine Kronenform aufweist, die ein Zentrum (60) umfaßt, das in der Symmetrieebene (24) angeordnet ist, und deren äußere Öffnung (61) über einen Durchgang (62) gegenüber der kleinen Basis (55) der polaren Teile (43, 44) des ersten Elements (41) in das Innere der Krone führt und durch zwei Seiten (63, 64), die jeweils den schrägen Seiten (53, 54) der polaren Teile (43, 44) des ersten Elements (41) gegenüberstehen, seitlich begrenzt ist.

8. Energiefilter (20) nach einem der vorstehenden Ansprüche, dadurch gekennzeichnet, daß das Ablenkungssystem (30) und das Streuungssystem (40) magnetische Abschnitte (30, 41, 42) umfassen, die jeweils ein Paar polarer Teile (31, 32, 43 - 46) sich gegenüberliegend aufweisen, durch einen Luftspalt (37,47, 48) getrennt, und die mit Aktivierungs-und Kontrollmitteln, die in jedem der Luftspalte (37,47, 48) ein gewünschtes magnetisches Feld erzeugen, verbunden sind, wobei die magnetischen Felder in jedem Luftspalt (37, 47, 48) einheitlich sind.

9. Elektronisches Mikroskop zur Übertragung (1), das mit einem Energiefilter (20) nach einem der Ansprüche 1 bis 8 ausgestattet ist.

10. Verfahren zum Filtern von Energie eines Elektronenstrahls (70), der sich entlang einer optischen Achse (5) in einer Ausbreitungsrichtung ausbreitet, in welchem:
- der Strahl (72) auf einem optischen Weg (80), der im Wesentlichen in einer Streuungsebene 23, die nicht die optische Achse (5) einschließt, eingeschrieben ist, so geführt wird, dass eine Streuung der Elektronel des Strahls (73) gemäß ihrer Energie erzeugt wird, wobei der Strahl (72) entlang einer Eintrittsstrecke (82) in die Streuungsebene (23) hereingelassen wird,
- der Strahl (73) in Ausrichtung zu der Achse (5) in der Ausbreitungsrichtung umgeleitet wird, wobei der Strahl (73) aus der Streuungsebene (23) entlang einer Austrittsstrecke (88), die kolinear zu der Eintrittsstrecke (82) verläuft, herausgelassen wird, und
- ein Energiefenster (22) räumlich ausgewählt wird, dadurch gekennzeichnet,
dass die Eintrittsstrecke (82) und die Austrittsstrecke (88) in entgegensetzter Richtung verlaufen.
